(19) Europäisches Patentamt
European Patent Office
Office européen des brevets

(11) **EP 2 887 190 A1**

(12) **EUROPEAN PATENT APPLICATION**

(43) Date of publication:
**24.06.2015 Bulletin 2015/26**

(51) Int Cl.:
***G06F 3/044*** *(2006.01)*

(21) Application number: **14195759.7**

(22) Date of filing: **02.12.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **20.12.2013 JP 2013263729**

(71) Applicant: **AISIN SEIKI KABUSHIKI KAISHA
Kariya-shi, Aichi 448-8650 (JP)**

(72) Inventor: **Sugiura, Takehiko
Kariya-shi,, Aichi 448-8650 (JP)**

(74) Representative: **TBK
Bavariaring 4-6
80336 München (DE)**

(54) **Capacitive sensor electrode**

(57) A capacitive sensor electrode (100) includes: a first electrode (102) that is disposed on a principal surface of a substrate (101); and a second electrode (103) that is disposed on the principal surface to be distant from the first electrodes, wherein the first electrode has a shape so as to be positioned on opposite sides of the second electrode.

## FIG.1A

## Description

### TECHNICAL FIELD

This disclosure relates to a capacitive sensor electrode.

### BACKGROUND DISCUSSION

In the related art, a capacitive sensor that detects a position or a motion of a detection object from a change in capacitance is known. The capacitive sensor includes one or plural detection electrodes. Capacitance values of the electrodes change along with an approach or a movement of a detection object. The capacitive sensor measures this change in capacitance value as an electric signal to detect the motion of the detection object. Recently, such a capacitive sensor is widely used as, for example, a non-contact object detector or a display touch panel.

JP 2012-203901A (Reference 1) discloses a capacitive sensor which is used in a display with a touch sensor. This capacitive sensor includes plural signal lines Tx and plural signal lines Rx crossing each other, and capacitances are formed between the signal lines Tx and the signal lines Rx. When a voltage is applied between the signal lines Tx and the signal lines Rx, an electric field is generated between the signal lines Tx and the signal lines Rx. When this electric field is interrupted by a finger of an operator, the amount of charge accumulated between the signal lines Tx and the signal lines Rx decreases. By measuring a change in the amount of charge, the capacitive sensor detects an approach of a finger, that is, an approach of a finger to the display. Such a capacitive sensor measures a change in mutual capacitances formed between the signal lines Tx and the signal lines Rx and thus is called a mutual capacitance type.

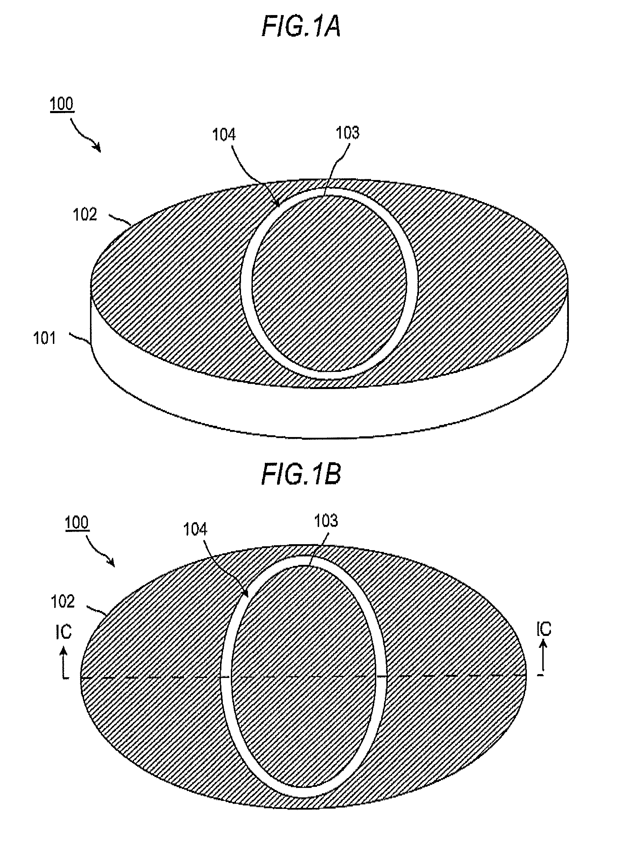

The mutual capacitance type capacitive sensor disclosed in Reference 1 detects a change in capacitance when an electric field between the signal lines Tx and the signal lines Rx is interrupted, for example, as illustrated in Figs. 1A and 1B of Reference 1. An electric field generated from the signal lines Tx is concentrated between the signal lines Tx and the signal lines Rx. Accordingly, when a change in capacitance is detected, the position of a detection object is specified to be near a position immediately above a gap between the lines Tx and Rx. As described above, the mutual capacitance type capacitive sensor has a detection range limited to a predetermined direction or range and thus is excellent in directivity.

However, since an electric field is concentrated between the lines as described above, the detection sensitivity rapidly decreases along with an increase in the distance between the sensor and a detection object. Therefore, it is difficult to use the mutual capacitance type capacitive sensor for a sensor distant from a detection object, for example, a vehicle proximity sensor, due to its insufficient detection sensitivity.

### SUMMARY

Thus, a need exists for a capacitive sensor electrode capable of improving the detection sensitivity of a mutual capacitance type capacitive sensor.

An aspect of this disclosure provides a capacitive sensor electrode including: a first electrode that is disposed on a principal surface of a substrate; and a second electrode that is disposed on the principal surface to be distant from the first electrodes, in which the first electrode has a shape so as to be positioned on opposite sides of the second electrode.

The capacitive sensor electrode according to the aspect of this disclosure may be configured such that a ratio of the area of the first electrode to the area of the second electrode is 2 or more.

The capacitive sensor electrode according to the aspect of this disclosure may be configured such that at least a part of an outer peripheral shape of the second electrode is curved,

The capacitive sensor electrode according to the aspect of this disclosure may be configured such that at least a part of an outer peripheral shape of the second electrode is a part of a Lame curve defined by the following expression (1).

$$\left|\frac{x}{a}\right|^{\alpha} + \left|\frac{y}{b}\right|^{\beta} = 1 \quad (1)$$

The capacitive sensor electrode according to the aspect of this disclosure may be configured such that, in the expression (1), $\alpha=2$.

The capacitive sensor electrode according to the aspect of this disclosure may be configured such that, in the expression (1), a=b.

The capacitive sensor electrode according to the aspect of this disclosure may be configured such that, in the expression (1), $1<\alpha<2$.

The capacitive sensor electrode according to the aspect of this disclosure may be configured such that, in the expression (1), $\alpha>2$.

The capacitive sensor electrode according to the aspect of this disclosure may be configured such that at least a part of an outer peripheral shape of the first electrode is curved.

The capacitive sensor electrode according to the aspect of this disclosure may be configured such that at least a part of an outer peripheral shape of the first electrode is a part of a Lame curve defined by the following expression (1).

$$\left|\frac{x}{a}\right|^{\alpha} + \left|\frac{y}{b}\right|^{\beta} = 1 \quad (1)$$

The capacitive sensor electrode according to the aspect of this disclosure may be configured such that, in the expression (1), $\alpha$=2.

The capacitive sensor electrode according to the aspect of this disclosure may be configured such that, in the expression (1), a≠b,

The capacitive sensor electrode according to the aspect of this disclosure may be configured such that, in the expression (1), 1<$\alpha$<2.

The capacitive sensor electrode according to the aspect of this disclosure may be configured such that, in the expression (1), $\alpha$>2.

The capacitive sensor electrode according to the aspect of this disclosure may be configured to further include: a third electrode having a ground potential that is positioned on the principal surface of the substrate or on another principal surface opposite the principal surface.

By configuring a mutual capacitance type capacitive sensor using the capacitive sensor electrode of this disclosure, the detection sensitivity can be improved.

BRIEF DESCRIPTION OF THE DRAWINGS

The foregoing and additional features and characteristics of this disclosure will become more apparent from the following detailed description considered with the reference to the accompanying drawings, wherein:

Fig. 1A is a perspective view illustrating a capacitive sensor electrode according to a first embodiment disclosed here;
Fig. 1B is a plan view illustrating the capacitive sensor electrode according to the first embodiment disclosed here;
Fig. 1C is a cross-sectional view taken along IC-IC line illustrating the capacitive sensor electrode according to the first embodiment disclosed here;
Fig. 2 is a cross-sectional view illustrating the capacitive sensor electrode according to the first embodiment disclosed here and a diagram illustrating drive circuits of a capacitive sensor;
Fig. 3 is a schematic diagram illustrating a distribution of electric force lines when a voltage is applied to the capacitive sensor electrode according to the first embodiment disclosed here;
Fig. 4 is a schematic diagram illustrating a change in the electric force lines when a detection object approaches the capacitive sensor electrode according to the first embodiment disclosed here;
Fig. 5 is a diagram illustrating a modification example of drive circuits used in the capacitive sensor electrode according to the first embodiment disclosed here;
Fig. 6A is a plan view illustrating a capacitive sensor electrode having a transmission/reception structure;
Fig. 6B is a plan view illustrating a capacitive sensor electrode having a transmission/reception/transmission structure;
Fig. 7 is a graph illustrating experiment results which indicate a difference in detection sensitivity between the transmission/reception structure and the transmission/reception/transmission structure;
Fig. 8A is a cross-sectional view illustrating the capacitive sensor electrode having a transmission/reception structure in the width direction and is a graph illustrating the detection sensitivity of a capacitive sensor;
Fig, 8B is a cross-sectional view illustrating the capacitive sensor electrode having a transmission/reception/transmission structure in the width direction and is a graph illustrating the detection sensitivity of a capacitive sensor;
Fig. 9 is a graph illustrating experiment results which indicate a variation in detection sensitivity depending on a ratio of the widths of transmission electrodes and a reception electrode;
Fig. 10A is a schematic diagram illustrating a capacitive sensor electrode in which a reception electrode has an elliptical shape;
Fig. 10B is a schematic diagram illustrating a capacitive sensor electrode in which a reception electrode has a perfectly circular shape;
Fig. 10C is a schematic diagram illustrating a capacitive sensor electrode in which a reception electrode has a rectangular shape;
Fig. 11 is a graph illustrating simulation results which indicate a variation in detection sensitivity depending on the shapes of capacitive sensor electrodes;
Fig. 12 is a diagram illustrating the shape of a Lame curve (superellipse);
Fig. 13 is a diagram illustrating a capacitive sensor electrode in which the outer shape of a transmission electrode is rectangular and the outer shape of a reception electrode is elliptical;
Fig. 14 is a cross-sectional view illustrating a capacitive sensor electrode according to a third embodiment disclosed here; and
Fig, 15 is a plan view illustrating a capacitive sensor electrode according to a fourth embodiment disclosed here.

DETAILED DESCRIPTION

Hereinafter, embodiments disclosed here will be described in detail with reference to the drawings. However, dimensions, materials, shapes, relative positions of components, and the like described in the following embodiments disclosed here are arbitrary and are changed depending on the structure of an apparatus according to this disclosure or various conditions. In addition, unless specified otherwise, the scope of this disclosure is not limited to specific configurations described in the following embodiments disclosed here. In the following description of the drawings, components having the same function are represented by the same reference numerals, and the description thereof will not be repeated.

First Embodiment

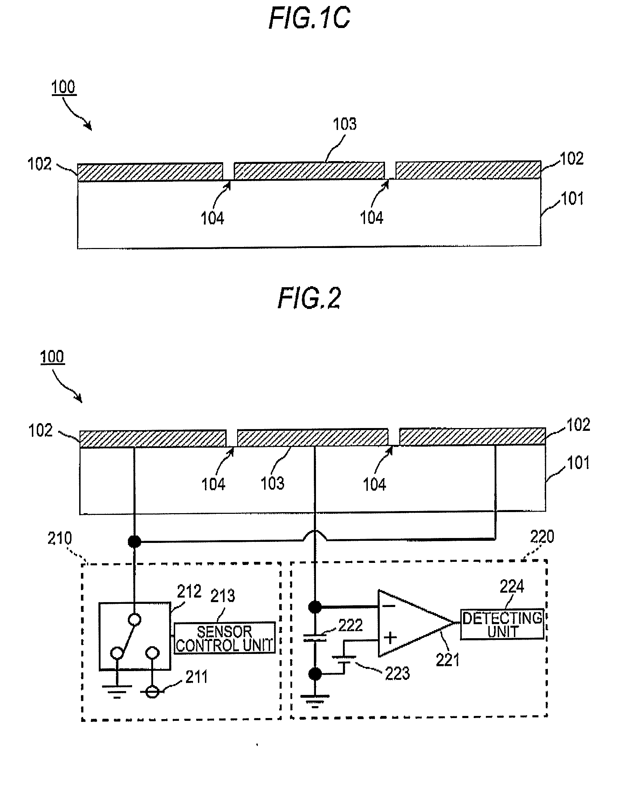

Figs. 1A, 1B, and 1C illustrate a structure of a capacitive sensor electrode according to a first embodiment disclosed here. Fig. 1A is a perspective view of the capacitive sensor electrode, Fig. 1B is a plan view of the capacitive sensor electrode, and Fig. 1C is a cross-sectional view taken along IC-IC line of Fig. 1B.

A capacitive sensor electrode 100 includes a transmission electrode 102 as a first electrode and a reception electrode 103 as a second electrode that are disposed on a principal surface of a substrate 101. The substrate 101 is an insulating substrate and may be formed of, for example, a resin or a glass. The transmission electrode 102 and the reception electrode 103 are disposed on the same principal surface of the substrate 101. The transmission electrode 102 and the reception electrode 103 are formed of, for example, conductive metal. The substrate 101 is not particularly limited as long as it includes a surface on which the capacitive sensor electrode is formed, and may not be a plate shape.

An outer periphery of the reception electrode 103 has an elliptical shape. The transmission electrode 102 has a ring shape having an inner periphery and an outer periphery and is disposed so as to surround the reception electrode 103 with a gap 104 interposed between the transmission electrode 102 and the reception electrode 103. That is, the gap 104 is formed as a ring-shaped trimmed pattern between the transmission electrode 102 and the reception electrode 103. An outer periphery of the transmission electrode 102 has an elliptical shape. A long axis of the elliptical shape forming the outer periphery of the transmission electrode 102 and a long axis of the elliptical shape forming the outer periphery of the reception electrode 103 have a position relationship of being perpendicular to each other. In the vertical section of the capacitive sensor electrode 100 of Fig. 1C taken along IC-IC line which passes through the long axis of the transmission electrode 102, the transmission electrode 102 is positioned on opposite sides of the reception electrode 103 with the gap 104 interposed between the transmission electrode 102 and the reception electrode 103. For example, the sizes of the long axis and the short axis of the transmission electrode 102 are 100 mm and 60 mm, respectively, and the sizes of the long axis and the short axis of the reception electrode 103 are 50 mm and 30 mm, respectively.

The capacitive sensor electrode 100 may further include an insulating film for covering at least a part of the transmission electrode 102 and the reception electrode 103. By providing the insulating film, deterioration such as corrosion of the transmission electrode 102 and the reception electrode 103 are prevented.

Fig. 2 is a cross-sectional view illustrating the capacitive sensor electrode according to the first embodiment disclosed here and a diagram illustrating drive circuits of a capacitive sensor using the capacitive sensor electrode. A voltage control section 210 and a capacitance detecting section 220 as the drive circuits are connected to the capacitive sensor electrode 100 through wiring.

The voltage control section 210 includes a power supply 211, a switch 212, and a sensor control unit 213. The power supply 211 supplies a DC voltage. The switch 212 is connected between the transmission electrode 102 of the capacitive sensor electrode 100 and the power supply 211. The switch 212 switches between ON (connection) and OFF (disconnection) of the supply of voltage to the transmission electrode 102 based on a control signal of the sensor control unit 213. When the switch 212 is switched to ON, a DC voltage is supplied from the power supply 211 to the transmission electrode 102. When the switch 212 is switched to OFF, the transmission electrode 102 is connected to the ground, and charge accumulated on the transmission electrode 102 is released. The sensor control unit 213 is not particularly limited as long as it has a function of transmitting a signal of controlling the switch 212, and this function can be implemented by a software program or by a hardware element such as an IC (not illustrated) for driving the capacitive sensor electrode 100. In the description of this specification, the voltage supplied from the power supply 211 is positive. However, the voltage may be negative, and in this case, directions of electric force lines in the drawing are reversed.

The capacitance detecting section 220 includes a comparator 221, a reference capacitance 222, a reference power supply 223, and a detecting unit 224. The comparator 221 includes a non-inverting input terminal, an inverting input terminal, and an output terminal. The inverting input terminal of the comparator 221 is connected to the reception electrode 103 and the reference capacitance 222. In Fig. 2, only the above-described three terminals are illustrated, but actually, the comparator 221 further includes one or more power terminals (not illustrated).

The reference capacitance 222 is connected between the inverting input terminal of the comparator 221 and the ground. The reference capacitance 222 divides the power supply voltage together with a capacitance between the transmission electrode 102 and the reception electrode 103. Accordingly, the capacitance value of the reference capacitance 222 is preferably set to be the same as the capacitance value between the transmission electrode 102 and the reception electrode 103.

The reference power supply 223 is connected between the non-inverting input terminal of the comparator 221 and the ground. The voltage of the reference power supply 223 is a reference voltage for comparing to the voltage of the reception electrode, and thus a voltage value is preferably set to be, for example, about 1/2 of the voltage of the power supply 211. The voltage of the reference power supply 223 may be supplied from the same power supply device by dividing the voltage of the power supply 211 or may be supplied from another power supply device having a different voltage.

The detecting unit 224 is connected to the output terminal of the comparator 221. The detecting unit 224 measures an output voltage of the comparator 221 and, based on this voltage value, determines whether or not an object which changes the capacitance between the transmission electrode 102 and the reception electrode 103 is present near the capacitive sensor electrode 100. The detecting unit 224 is not particularly limited as long as it has functions of: measuring an output voltage of the comparator 221; and, based on this output voltage, transmitting a control signal to another device. This function can be implemented by a software program or by a hardware element such as an IC (not illustrated).

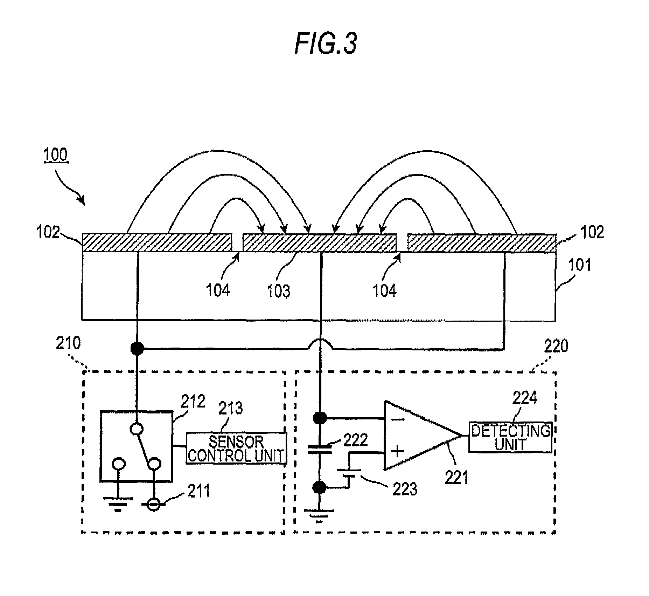

Fig. 3 is a schematic diagram illustrating a distribution of electric force lines during voltage application. When the switch 212 is switched to ON, the voltage of the power supply 211 is applied to the transmission electrode 102, and electric force lines moving from the transmission electrode 102 to the reception electrode 103 are generated.

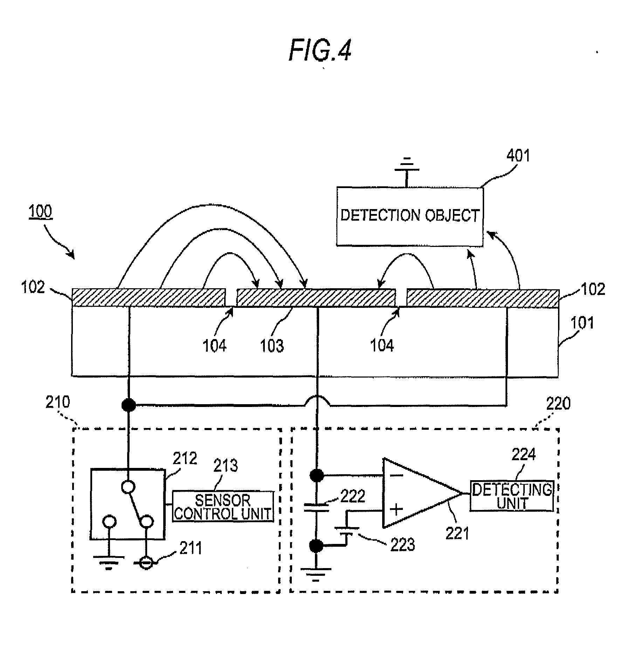

Fig. 4 is a schematic diagram illustrating a change in the electric force lines when a detection object approaches the capacitive sensor electrode. When a detection object 401 approaches a position near the capacitive sensor electrode 100, some of the electric force lines moving from the transmission electrode 102 to the reception electrode 103 move to the detection object 401. Accordingly, the number of electric force lines received in the reception electrode 103 decreases.

The operations of the capacitive sensor electrode 100, which detects an approach of the detection object 401 to the capacitive sensor electrode 100, and a control circuit thereof will be described. A voltage value supplied from the power supply 211 to the transmission electrode 102 is set as Vdd. As described above, since the electric force lines are generated between the transmission electrode 102 and the reception electrode 103, a capacitance is formed between the transmission electrode 102 and the reception electrode 103. A capacitance value of this capacitance is set as Cs. The reception electrode 103 is connected to the ground through the reference capacitance 222 of the capacitance detecting section 220. A capacitance value of the reference capacitance 222 is set as Cref.

The voltage Vdd is divided by the capacitances Cs and Cref to be input to the inverting input terminal of the comparator 221. That is, a voltage Vin input to the inverting input terminal of the comparator 221 is calculated from $Vin=\{Cs/(Cref+Cs)\}\cdot Vdd$. On the other hand, a voltage input to the non-inverting input terminal of the comparator 221 is a voltage of the reference power supply 223. This voltage is set as Vref.

The comparator 221 compares the voltages of the inverting input terminal and the non-inverting input terminal to each other and outputs a high-level or low-level signal. When the voltage of the non-inverting input terminal is higher, a high-level voltage is output, and when the voltage of the inverting input terminal is higher, a low-level voltage is output. That is, a voltage output from the output terminal of the comparator 221 is at a high level when Vin<Vref and is at a low level when Vin>Vref. For example, at a setting of Vref=Vdd/2, the voltage output from the output terminal of the comparator 221 is at a high level when Cs<Cref and is at a low level when Cs>Cref. Accordingly, the comparator 221 outputs a high-level or low-level voltage signal to the detecting unit 224, the voltage signal indicating a magnitude relation of the capacitance between the transmission electrode 102 and the reception electrode 103 and the reference capacitance 222.

In the initial state where the detection object 401 is not present, Cs is set to satisfy Cs>Cref. At this time, a low-level voltage is input to the detecting unit 224. As described above, when the detection object 401 approaches the capacitive sensor electrode 100, electric force lines between the transmission electrode 102 and the reception electrode 103 are interrupted, and the capacitance Cs decreases. When Cs decreases due to the approach of the detection object 401 and Cs<Cref is established, the voltage input to the detecting unit 224 changes from a low level to a high level. By detecting this change in voltage level, the approach of the detection object 401 can be detected.

As described above, the capacitive sensor electrode 100 according to the first embodiment disclosed here can be adopted for a mutual capacitance type capacitive sensor which detects a change in capacitance when electric force lines generated between the transmission electrode 102 and the reception electrode 103 are interrupted. Since the mutual capacitance type is adopted, an electric field is concentrated in the vicinity of the gap 104. Accordingly, the detection object 401 is detected when being near the gap 104. Accordingly, when a large object is present at a position distant from the capacitive sensor electrode 100, erroneous detection does not occur. For example, it is not determined that a small object is detected near the gap 104. In this specification, a property in which the detection range is limited to a predetermined direction or range as described above is expressed by "the detection sensitivity being excellent in directivity".

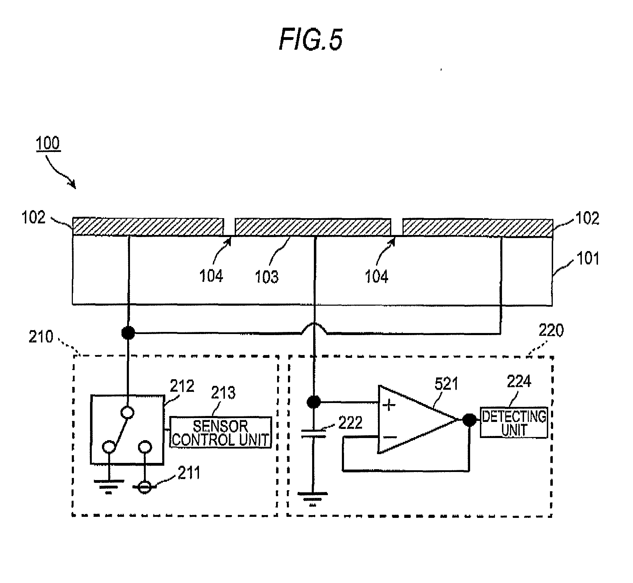

As the circuit of the capacitance detecting section 220, the comparator circuit using the comparator 221 has been described as an example. However, other circuits may be used as long as they can measure a change in the capacitance between the transmission electrode 102 and the reception electrode 103. For example, a circuit including a negative feedback unit such as a voltage follower circuit using a differential amplifier 521 as illustrated in Fig. 5 may be used. In an example of Fig. 5, a non-inverting input terminal is connected to the reception electrode 103, and an inverting input terminal is connected to an output terminal. At this time, when a voltage of the non-inverting input terminal is set as Vin, a voltage of the output terminal, that is, a voltage input to the detecting unit 224 is also Vin. A voltage signal input to the detecting unit 224 is not binary data containing a high-level value and a low-level value but analog data containing continuous values. Accordingly, a change in the capacitance between the transmission electrode 102 and the reception electrode 103 can be detected in more detail as compared to the case of the binary data. In this example, an AD converter may be disposed in a stage after the output terminal of the comparator 221 so as to convert a voltage signal to digital data suitable for signal processing. By further providing, for example, a resistance element in addition to the negative feedback unit and the like, a voltage amplifying circuit may be adopted instead of the voltage follower circuit.

The effects and the technical grounds of the first embodiment disclosed here will be described with reference to the results of an experiment and a simulation which were performed by the present inventors to examine the structure of the capacitive sensor electrode according to the first embodiment disclosed here.

Regarding Distribution of Transmission Electrode and Reception Electrode

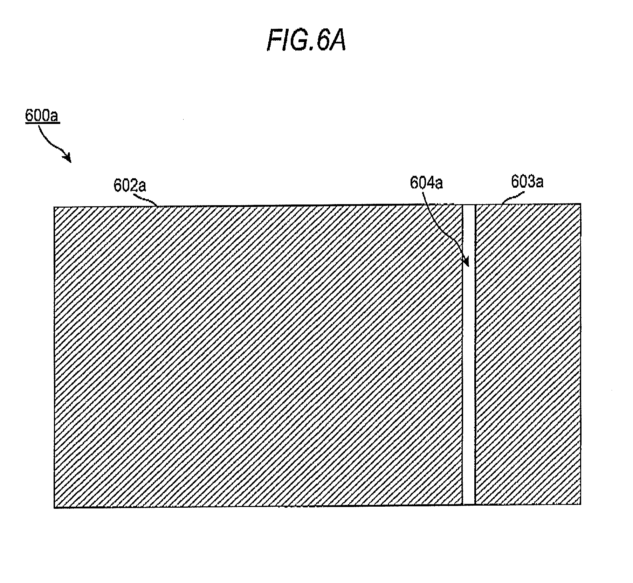

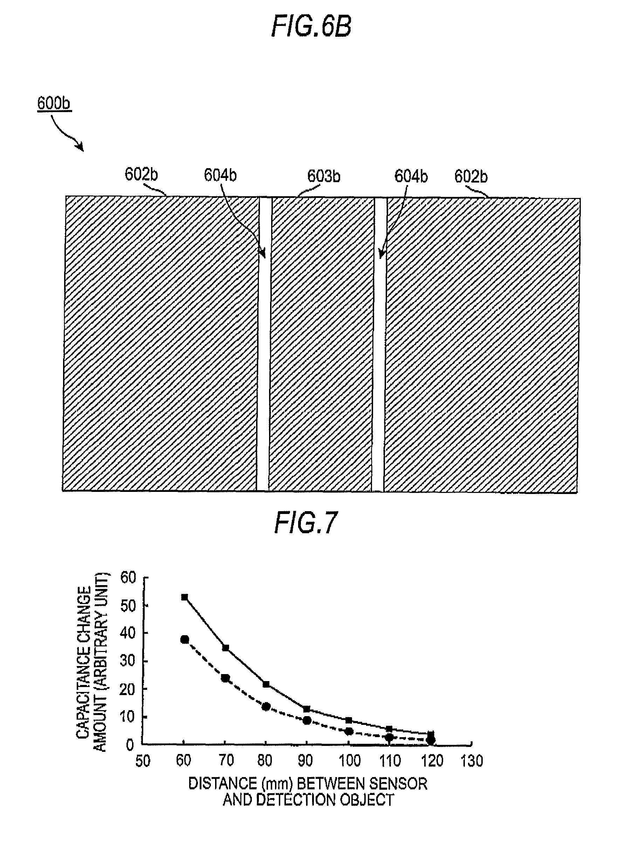

Figs. 6A and 6B are diagrams illustrating experiment results of comparing a structure in which a transmission electrode and a reception electrode are disposed in parallel and a structure in which a transmission electrode is disposed on opposite sides of a reception electrode. Fig. 6A is a plan view illustrating a capacitive sensor electrode 600a. A transmission electrode 602a and a reception electrode 603a are disposed in parallel with a gap 604a interposed between the transmission electrode 602a and the reception electrode 603a (hereinafter, this structure will be referred to as "transmission/reception structure"). Fig, 6B is a plan view illustrating a capacitive sensor electrode 600b for comparison to Fig. 6A. Transmission electrodes 602b are disposed so as to surround a reception electrode 603b with gaps 604b interposed between the respective transmission electrodes 602b and the reception electrode 603b (hereinafter, this structure will be referred to as "transmission/reception/transmission structure"). These capacitive sensor electrodes 600a and 600b were prepared to perform an experiment of measuring a change in capacitance when an detection object approaches each of the capacitive sensor electrodes 600a and 600b. In this experiment, for easy understanding of the phenomenon and easy preparation of samples, the structures of the electrodes are simplified to be rectangular as illustrated in the drawings instead of being elliptical as in the first embodiment disclosed here.

Fig. 7 is a graph illustrating experiment results which indicate a difference in detection sensitivity between the transmission/reception structure and the transmission/reception/transmission structure. In the graph, the horizontal axis represents the distance (mm) between the capacitive sensor electrodes 600a and 600b and the detection object, and the vertical axis represents a capacitance change amount (arbitrary unit) when the detection object approaches the capacitive sensor electrodes 600a and 600b. The reason for expressing the capacitance change amount by an arbitrary unit is that capacitance data acquired from a capacitance measuring device is based on a unique parameter of the device and cannot be converted into a general unit system such as SI. In the graph of Fig, 7, data indicated by a broken line represents a measured value of the transmission/reception structure, and data indicated by a solid line represents a measured value of the transmission/reception/transmission structure. It can be understood from this graph that the capacitance change amount of the transmission/reception/transmission structure is about 1.4 times to 2 times that of the transmission/reception structure, and the detection sensitivity is excellent. In this experiment, in both of the structures, the total size of each of the regions where the transmission electrodes 602a and 602b and the reception electrodes 603a and 603b were disposed, respectively, was 100 mm×60 mm, and an area ratio of the transmission electrode to the reception electrode was set to be 4:1.

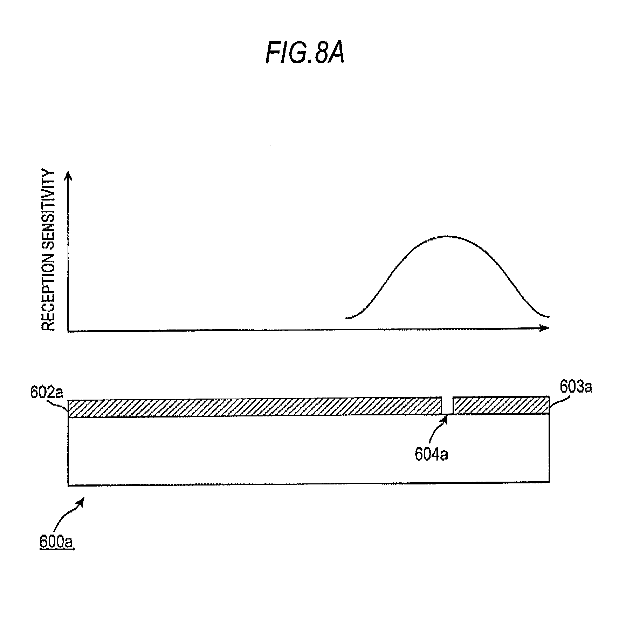

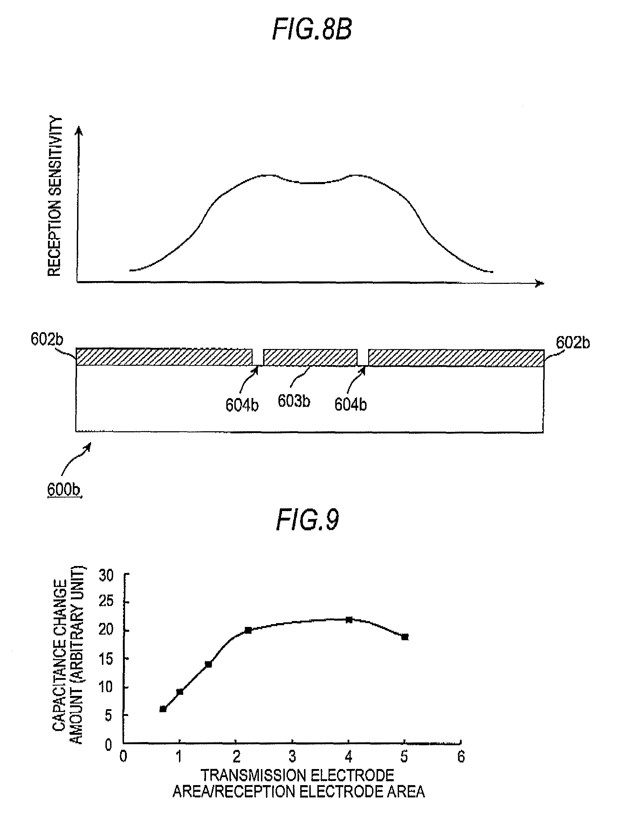

Figs. 8A and 8B are schematic diagrams illustrating a difference in detection sensitivity between the transmission/reception structure and the transmission/reception/transmission structure. Fig. 8A is a cross-sectional view illustrating the capacitive sensor electrode 600a having a transmission/reception structure of Fig. 6A in the width direction and is a graph illustrating the detection sensitivity of the capacitive sensor electrode 600a at each position of the width direction. When electric force lines moving from the transmission electrode 602a to the reception electrode 603a are interrupted by the detection object, this interruption is detected as a change in capacitance. Therefore, the sensitivity of a position near the gap 604a between the transmission electrode 602a and the reception electrode 603a is the highest. Accordingly, it is considered that the graph is plotted in a bell shape in which the detection sensitivity has a peak near the gap 604a.

Fig. 8B illustrates the detection sensitivity of the capacitive sensor having a transmission/reception/transmission structure contrary to the above detection sensitivity. The description of the drawing and the graph are the same as those In Fig. 8A and thus will not be repeated. As in the case of the transmission/reception structure, in the transmission/reception/transmission structure, the sensitivity of positions near the gaps 604b between the respective transmission electrodes 602b and the reception electrode 603b is also the highest. However, since the two gaps are adjacent to each other, peaks of the detection sensitivity strengthen each other, Accordingly, it is considered that the detection range also increases along with the improvement of the detection sensitivity. It is considered that, by this mechanism, the capacitance change amount of the transmission/reception/transmission structure is greater in the experiment results of Fig. 7. For the above-described reason, the reception sensitivity of a capacitive sensor is improved by adopting the transmission/reception/transmission structure, that is, the structure in which transmission electrodes surround a reception electrode with gaps interposed between the respective transmission electrodes and the reception electrode.

As can be understood from Fig. 8B and the above description thereof, the peak intensity and the range of the detection sensitivity can be adjusted by adjusting the distance between the two gaps. When the distance between the gaps is narrowed, the peaks strengthen each other, and the detection sensitivity is further improved. When the distance between the gaps is widened, the detection sensitivity decreases, but the detection range is further widened. In this way, a relationship between the detection sensitivity and the detection range can be adjusted by distance between the gaps. As can be seen from Fig. 6B, the distance between the gaps is determined by the width of the reception electrode 603b. Therefore, experiment results of investigating the width of a reception electrode will be described.

Regarding Ratio of Areas of Transmission Electrodes and Reception Electrode

Fig. 9 is a graph illustrating experiment results which indicate a variation in detection sensitivity depending on a ratio of the areas of transmission electrodes and a reception electrode. In the graph, the horizontal axis represents the distance (mm) between a sensor and a detection object, and the vertical axis represents a capacitance change amount (arbitrary unit) when the detection object approaches the sensor, In the experiment results, "area of transmission electrodes" represents the total area of transmission electrodes surrounding a reception electrode. In this graph, when an area ratio of the transmission electrodes to the reception electrode is within a range of 2:1 to 4:1, the capacitance change amount is about 2 times that of a case where the area ratio is 1:1. However, when the area ratio of the transmission electrodes is more than 4:1, the capacitance change amount tends to decrease. That is, the area ratio of the transmission electrodes to the reception electrode is particularly preferably within a range of 2:1 to 4:1. The reason why the above results are obtained is considered to be as follows. When the area of the transmission electrodes increases, electric force lines generated from the transmission electrodes are distributed in a wide range. However, when the area of the reception electrode excessively decreases, the number of electric force lines which can be received in the reception electrode decreases. In this experiment, the structure of the capacitive sensor electrode had the same transmission/reception/transmission structure as that illustrated in Fig. 6B, and in a state where the total size thereof was fixed to 100 mm×60 mm, the area ratio of the transmission electrodes to the reception electrode was changed. The distance between the capacitive sensor electrode and the detection object was 80 mm.

Regarding Shapes of Transmission Electrode and Reception Electrode

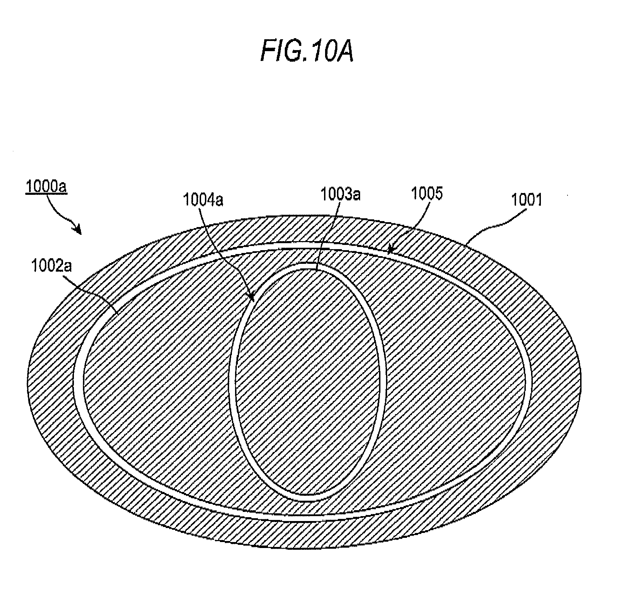

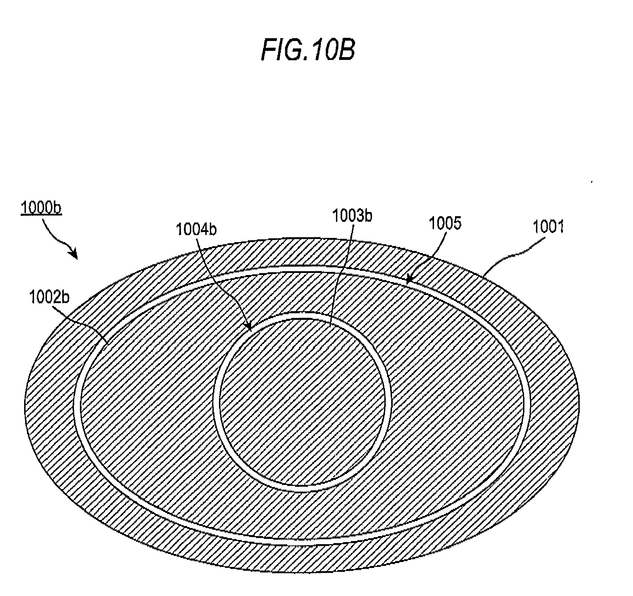

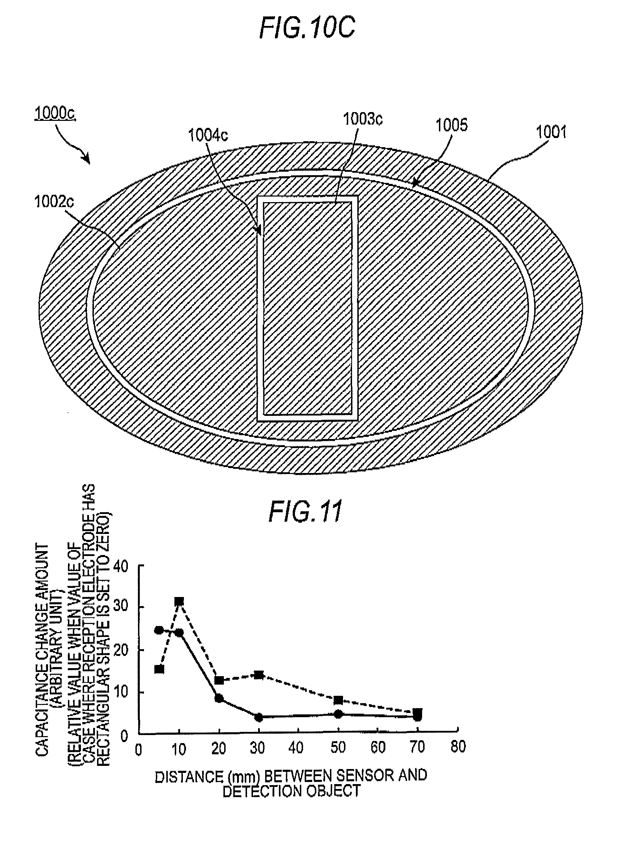

A change in detection sensitivity depending on the shapes of a transmission electrode and a reception electrode in a top view was simulated using an electric field simulation program based on a finite element method. Figs. 10A, 10B, and 10C are plan views schematically illustrating the shapes of electrodes which are targets of the simulation. These diagrams are conceptual diagrams for illustrating the shapes of the electrodes and are not the same as actual simulation models.

Fig. 10A is a schematic diagram illustrating the shape of a capacitive sensor electrode model 1000a in which a reception electrode 1003a has an elliptical shape. The reception electrode 1003a has an elliptical shape. A transmission electrode 1002a has a hollow shape and is disposed so as to surround the reception electrode 1003a with a gap 1004a interposed between the transmission electrode 1002a and the reception electrode 1003a. An outer periphery of the transmission electrode 1002a has an elliptical shape. A ground electrode 1001 is disposed on the outside of the transmission electrode 1002a with a gap 1005 interposed between the transmission electrode 1002a and the ground electrode 1001. The ground electrode 1001 is provided in consideration of an influence of, for example, a case where a metal member, which may be present near the capacitive sensor electrode 1000a when the capacitive sensor electrode 1000a is actually installed, acts as the ground. In addition, when the capacitive sensor electrode 1000a is actually manufactured, the ground electrode 1001 may be disposed on the outer periphery of the capacitive sensor electrode 1000a to reduce an error caused by ground wiring or the like which may be present near the capacitive sensor electrode 1000a.

Fig. 10B is a schematic diagram illustrating the shape of a capacitive sensor electrode model 1000b in which a reception electrode 1003b has a perfectly circular shape. Fig. 10C is a schematic diagram illustrating the shape of a capacitive sensor electrode model 1000c in which a reception electrode 1003c has a rectangular shape. Since the configurations other than the shape of each of the electrodes are the same as those of the capacitive sensor electrode model 1000a illustrated in Fig. 10A, the detailed description thereof will not be repeated.

Fig. 11 is a graph illustrating simulation results which indicate a variation in detection sensitivity depending on the shapes of the capacitive sensor electrodes illustrated in Figs. 10A, 10B, and 10C. In the graph, the horizontal axis represents the distance (mm) between a sensor and a detection object, and the vertical axis represents a capacitance change amount (arbitrary unit) when the detection object approaches the sensor. A solid-line graph represents the results of the case where the reception electrode has an elliptical shape as illustrated in Fig. 10A, and a broken-line graph represents the results of the case where the reception electrode has a perfectly circular shape as illustrated in Fig, 10B. In each capacitance change amount data illustrated in the graph, unique error factors of the simulation are excluded therefrom. Therefore, the capacitance change amount data is corrected by subtracting measurement data of the case of Fig. 10C where the reception electrode has a rectangular shape therefrom. That is, in this graph, data is plotted as a relative comparative value when the value of the case where the reception electrode has a rectangular shape is set to reference (zero). Accordingly, when a value of each graph is positive, a change in capacitance when the detection object approaches the capacitive sensor electrode is larger, and the sensitivity of the capacitive sensor is higher as compared to the case where the reception electrode has a rectangular shape. It can be understood from the above results that, in either case where the reception electrode has an elliptical shape or a perfectly circular shape, a capacitance change amount is larger than that of the case where the reception electrode has a rectangular shape.

In the case where the reception electrode has a rectangular shape, the gap between the transmission electrode and the reception electrode is linear. Therefore, electric force lines to be generated are substantially parallel to each other and are not likely to be concentrated. On the other hand, in the case where the reception electrode has an elliptical shape or a perfectly circular shape, the gap between the transmission electrode and the reception electrode is arc-shaped or curved. Therefore, electric force lines are more likely to be concentrated as compared to the case where the reception electrode has a rectangular shape. As a result, it is considered that a capacitance change amount increases when the detection object approaches the capacitive sensor electrode. For the above-described reason, it is more preferable that the reception electrode have an elliptical shape or a perfectly circular shape having an arc-shaped or curved end portion.

The shape of an ellipse is determined by two parameters including the length of a long axis and the length of a short axis. On the other hand, the shape of a perfect circle is determined by only one parameter of a radius (or a diameter). As described above, an area ratio of a transmission electrode to a reception electrode is one of the parameters which determine the detection sensitivity of a capacitive sensor. However, a perfectly circular electrode has a low degree of freedom for design because the width thereof cannot be changed at a fixed area. On the other hand, an elliptical electrode has a high degree of freedom for design because the width thereof can be changed at a fixed area by changing a ratio of the length of a long axis to the length of a short axis. Accordingly, it is preferable that a reception electrode has an elliptical shape.

It has been described with reference to the simulation results that the detection sensitivity is excellent when a reception electrode has an elliptical shape rather than a rectangular shape. However, even if a reception electrode has a rectangular shape, at least some of the effects of the disclosure can be obtained. Accordingly, it is not intended that a case where a reception electrode has a rectangular shape is excluded from the disclosure.

When a gap between a transmission electrode and a reception electrode is arc-shaped or curved, a mechanism in which electric force lines are more concentrated can be achieved, and the effect of improving the detection sensitivity can be obtained as in the case where a reception electrode has an elliptical shape. As specific examples of a figure having an arc-shaped or curved end portion, in addition to a perfect ellipse, an intermediate shape between a rectangle and an ellipse or an intermediate shape between a rhombus and an ellipse may be used. For example, an electrode shape may be a Lame curve (superellipse) represented by the following expression (1) which Is a generalized figure of a circle, an ellipse, a rectangle, a rhombus, and the like.

$$\left|\frac{x}{a}\right|^{\alpha} + \left|\frac{y}{b}\right|^{\beta} = 1 \quad (1)$$

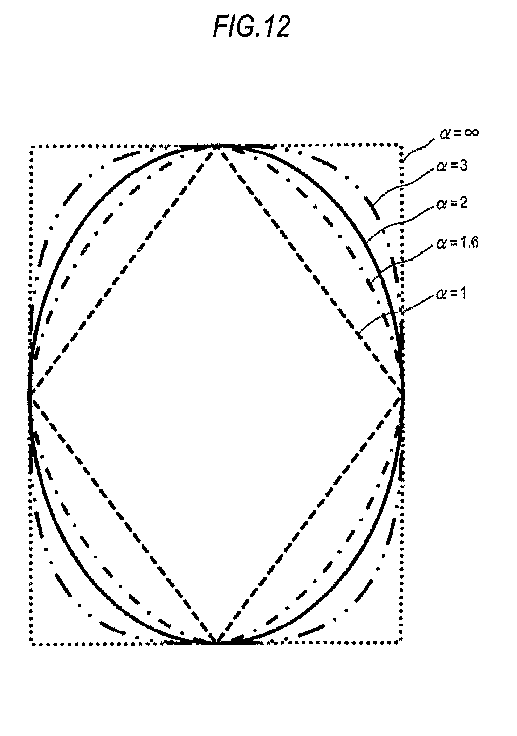

Fig. 12 illustrates each of curves when $\alpha=1$, 1.6, 2, 3, and infinite ($\infty$) in the Lame curve represented by the expression (1). When $\alpha=1$, the Lame curve is a rhombus, When $\alpha=2$ and $a \neq b$, the Lame curve is an ellipse. When $\alpha=2$ and $a=b$, the Lame curve is a perfectly circular shape. When $\alpha=\infty$, the Lame curve is a rectangle. When $\alpha=1.6$, the Lame curve is an intermediate shape between a rhombus and an ellipse. When $\alpha=3$, the Lame curve is an intermediate shape between an ellipse and a rectangle. For example, when $2<\alpha<\infty$, the Lame curve is a shape closer to a rectangle rather than an ellipse. Therefore, a dead space decreases, and the utilization efficiency of the element area is improved. For example, when $1<\alpha<2$, electric force lines can be more concentrated than the case of an ellipse. In the Lame curve, a and b are parameters which determine the lengths of a short axis and a long axis, and as described above, it is preferable that $a \neq b$.

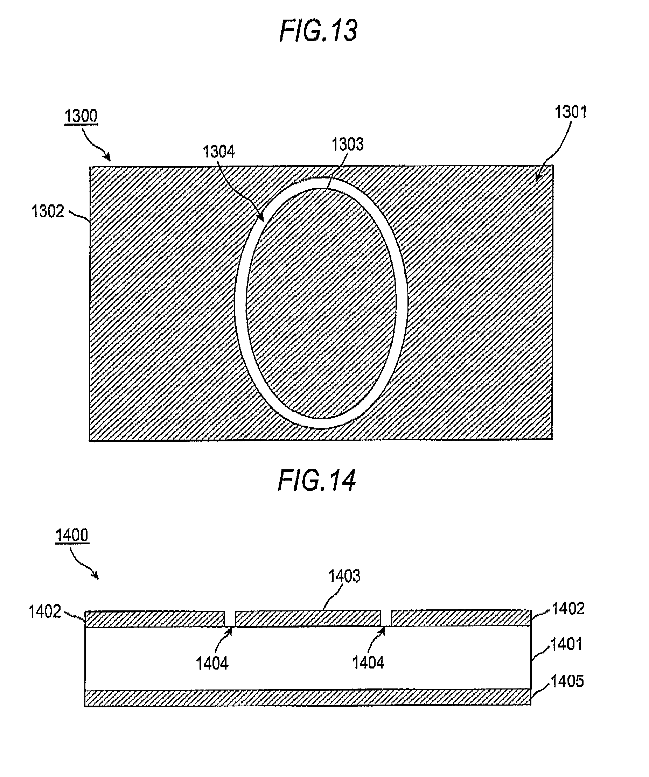

The outer peripheral shape of a transmission electrode will be described. As described above, it is preferable that the shape of a reception electrode and the shape of the inner periphery of a transmission electrode surrounding the reception electrode be elliptical. On the other hand, it is preferable that the outer peripheral shape of a transmission electrode be elliptical as illustrated in Figs. 1A to 1C. For example, as illustrated in Fig. 13, when a reception electrode 1303 of a capacitive sensor electrode 1300 has an elliptical shape and a transmission electrode 1302 thereof has a rectangular shape, a portion near a corner 1301 of the transmission electrode is more distant from the reception electrode than the other portions. Therefore, the percentage of electric force lines which are generated from the corner 1301 and are received in the reception electrode 1303 is low. As a result, since the detection sensitivity may deteriorate, a shape not having the corner 1301 is preferable. When a reception electrode has an elliptical shape, the above-described problem can be solved by setting the outer peripheral shape of a transmission electrode to be elliptical. For the above-described reason, when the outer peripheral shape of a reception electrode is rectangular, it is preferable that the outer peripheral shape of a transmission electrode be rectangular. When the outer peripheral shape of a reception electrode is a Lame curve having a coefficient $\alpha$, it is preferable that the outer peripheral shape of a transmission electrode be a Lame curve having a coefficient close to $\alpha$. That is, it is preferable that a reception electrode and the outer periphery of a transmission electrode have the same shape.

Using the results of the experiment and the simulation described above, the following facts have been described: it is preferable that a transmission electrode be disposed so as to surround a reception electrode with a gap interposed between the transmission electrode and the reception electrode; it is preferable that a ratio of the width of the transmission electrode to the width of the reception electrode be within a range of 2 to 9; and it is preferable that the reception electrode have an elliptical shape and the outer peripheral shape of the transmission electrode also have an elliptical shape. The capacitive sensor electrode 100 according to the first embodiment disclosed here is configured in consideration of the above-described conditions. Therefore, a change in capacitance is large when a detection object approaches the capacitive sensor electrode 100, and the detection sensitivity is high. In addition, since the mutual capacitance type is adopted, the directivity of the detection sensitivity is also high. With the above-described configurations, a capacitive sensor in which the capacitive sensor electrode 100 according to the first embodiment disclosed here is used can achieve the excellent directivity and the improvement of the detection sensitivity at the same time.

In order to obtain the effects of the embodiment disclosed here, all the conditions described above are not necessarily satisfied. Even when some of the conditions are satisfied, the same effects can be obtained. Accordingly, the disclosure is not limited to the embodiment which is specifically described above. For example, the shapes of a transmission electrode and a reception electrode may be modified into various shapes other than the above-described shapes. For example, the shapes of a transmission electrode and a reception electrode may be vertically or horizontally asymmetric.

Second Embodiment

A capacitive sensor electrode according to a second embodiment disclosed here includes a ground electrode that is disposed near a transmission electrode with a gap interposed between the transmission electrode and the ground electrode as in the case of the simulation models described above in Figs. 10A to 10C. When the ground electrode is disposed near the transmission electrode, electric force lines spreading toward the vicinity of the capacitive sensor electrode are absorbed in the ground electrode and are not diffused to the vicinity of the capacitive sensor electrode. As a result, when an object formed of a conductor material approaches to the capacitive sensor electrode, a distribution of electric force lines generated from the transmission electrode changes and can prevent a problem of erroneous detection.

Third Embodiment

Fig. 14 illustrates a capacitive sensor electrode according to a third embodiment disclosed here. Fig. 14 is a diagram illustrating a cross-section of the capacitive sensor electrode corresponding to the cross-section taken along IC-IC line of Fig. 1B; and illustrating a modification example of the configuration of Fig. 1C. A capacitive sensor electrode 1400 illustrated in Fig 14 includes a transmission electrode 1402 and a reception electrode 1403 that are disposed on a principal surface of a substrate 1401 and further includes a ground electrode 1405 that is disposed on another principal surface (hereinafter referred to as "back surface") opposite the principal surface. It is preferable that the ground electrode 1405 be disposed such that at least a part of the transmission electrode 1402 and the reception electrode 1403 is opposite the ground electrode 1405 with the substrate 1401 interposed between at least the part of the transmission electrode 1402 and the reception electrode 1403 and the ground electrode 1405. By disposing the ground electrode 1405 as described above, electric force lines moving from the transmission electrode 1402 to the reception electrode 1403 through the back surface side of the substrate are absorbed in the ground electrode 1405, and the sensitivity in the back surface side direction of the substrate 101 significantly decreases. Accordingly, the capacitive sensor electrode 1400 is not likely to be affected by whether or not an object is present on the back surface side of the substrate 1401, and the detection using the capacitive sensor electrode 1400 is stabilized. The configuration according to the third embodiment disclosed here may be combined with the configuration according to the second embodiment in which the ground electrode is disposed near the transmission electrode.

When a capacitive sensor is used for, for example, an exterior member of a vehicle, a change in capacitance may be erroneously detected, for example, due to an approach of an object from the back surface of the capacitive sensor electrode or due to a shake of an interior member of a vehicle or a wire harness. A capacitive sensor including the capacitive sensor electrode 1400 according to the third embodiment disclosed here includes the ground electrode disposed on the back surface. As a result, the detection sensitivity in the back surface side direction of the capacitive sensor electrode 1400 significantly decreases. A decrease in the detection sensitivity on the back surface side caused by the ground electrode has a higher effect on a mutual capacitance type capacitive sensor than on a self-capacitance type. The capacitive sensor electrode 1400 according to the third embodiment disclosed here is used for a mutual capacitance type capacitive sensor and thus can effectively decrease the detection sensitivity on the back surface side. Accordingly, the possibility of erroneous detection due to the above-described factors may be significantly reduced or prevented.

Fourth Embodiment

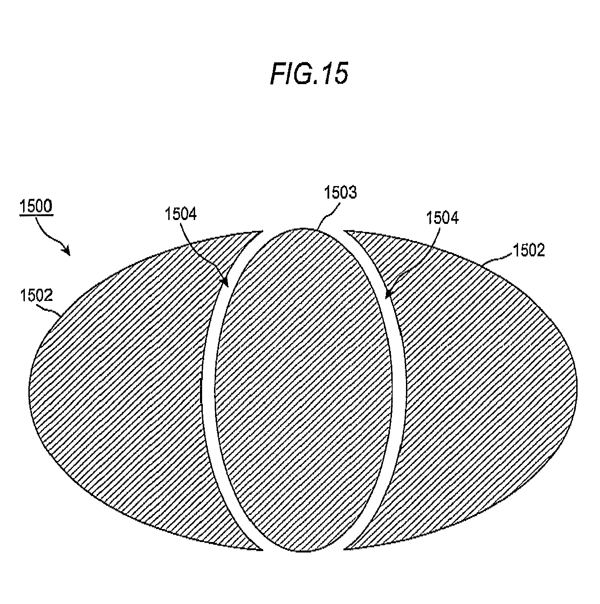

Fig. 15 is a plan view illustrating a capacitive sensor electrode according to a fourth embodiment disclosed here. A capacitive sensor electrode 1500 illustrated in Fig. 15 has a structure in which two transmission electrodes 1502 are disposed on opposite sides of a reception electrode 1503. The transmission electrodes 1502 have the same potential and are connected to each other on wiring which is led out to a drive circuit of a sensor by a lead-out wiring (not illustrated). Even if the two divided transmission electrodes 1502 are provided, the same effects as those of the first to third embodiments disclosed here can be obtained as long as the two transmission electrodes 1502 are connected to have the same potential.

Other Embodiments

A capacitive sensor using the capacitive sensor electrode according to any one of the embodiments disclosed here can be suitably used as a non-contact switch for operating an opening and closing body such as a sliding door or a back door of a vehicle. Since the reception sensitivity is improved, the capacitive sensor according to any one of embodiments disclosed here can obtain sufficient sensitivity even if the surface thereof is coated and protected with a resin or the like, and can also be installed in an exterior member such as a sliding door of a vehicle. Further, since the capacitive sensor according to any one of embodiments disclosed here is a mutual capacitance type capacitive sensor, the detection range is limited to a position immediately above the sensor, Therefore, erroneous detection is not likely to occur, and a decrease in sensitivity caused by a metal vehicle body being present near the capacitive sensor is not likely to occur. In addition, since the surface of the capacitive sensor can be coated with a resin or the like as described above, a decorative indicator for notifying the user of the presence of a non-contact switch can be provided above the capacitive sensor. By disposing the capacitive sensor inside an emblem of a vehicle, the capacitive sensor can also function to indicate a manufacturer or a car model or to indicate a non-contact switch.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

A capacitive sensor electrode (100) includes: a first electrode (102) that is disposed on a principal surface of a substrate (101); and a second electrode (103) that is disposed on the principal surface to be distant from the first electrodes, wherein the first electrode has a shape so as to be positioned on opposite sides of the second electrode.

**Claims**

1. A capacitive sensor electrode (100) comprising:

   a first electrode (102) that is disposed on a principal surface of a substrate (101); and
   a second electrode (103) that is disposed on the principal surface to be distant from the first electrodes,
   wherein the first electrode has a shape so as to be positioned on opposite sides of the second electrode.

2. The capacitive sensor electrode according to claim 1,
   wherein a ratio of the area of the first electrode to the area of the second electrode is 2 or more.

3. The capacitive sensor electrode according to claim 1 or 2,
   wherein at least a part of an outer peripheral shape of the second electrode is curved.

4. The capacitive sensor electrode according to any one of claims 1 to 3, wherein at least a part of an outer peripheral shape of the second electrode is a part of a Lame curve defined by the following expression (1):

$$\left|\frac{x}{a}\right|^{\alpha} + \left|\frac{y}{b}\right|^{\beta} = 1 \quad (1).$$

5. The capacitive sensor electrode according to claim 4,
   wherein in the expression (1), $\alpha=2$.

6. The capacitive sensor electrode according to claim 5,
   wherein in the expression (1), $a \neq b$.

7. The capacitive sensor electrode according to claim 4,
   wherein in the expression (1), $1<\alpha<2$.

8. The capacitive sensor electrode according to claim 4,
   wherein in the expression (1), $\alpha>2$.

9. The capacitive sensor electrode according to any one of claims 1 to 8,
   wherein at least a part of an outer peripheral shape of the first electrode is curved.

10. The capacitive sensor electrode according to any one of claims 1 to 8,
    wherein at least a part of an outer peripheral shape of the first electrode is a part of a Lame curve defined by the following expression (1):

$$\left|\frac{x}{a}\right|^{\alpha} + \left|\frac{y}{b}\right|^{\beta} = 1 \quad (1).$$

11. The capacitive sensor electrode according to claim 10.
    wherein in the expression (1), $\alpha=2$.

12. The capacitive sensor electrode according to claim 11,
    wherein in the expression (1), $a \neq b$.

13. The capacitive sensor electrode according to claim 10,
    wherein in the expression (1), $1<\alpha<2$.

14. The capacitive sensor electrode according to claim 10,
    wherein in the expression (1), $\alpha>2$.

15. The capacitive sensor electrode according to any one of claims 1 to 14, further comprising;

a third electrode (1403) having a ground potential that is positioned on the principal surface of the substrate or on another principal surface opposite the principal surface.

*FIG.1A*

*FIG.1B*

## FIG.1C

100

103

102

102

104        104

101

## FIG.2

100

102

102

104      103      104

101

210                                          220

212  213                                    224

SENSOR
CONTROL UNIT          222          DETECTING
UNIT

211          223          221

## FIG.3

# FIG.4

## FIG.5

# FIG.6A

600a

602a      604a      603a

## FIG.6B

600b

602b    604b    603b    604b    602b

## FIG.7

CAPACITANCE CHANGE AMOUNT (ARBITRARY UNIT)

60
50
40
30
20
10
0

50    60    70    80    90    100    110    120    130

DISTANCE (mm) BETWEEN SENSOR AND DETECTION OBJECT

# FIG.8A

RECEPTION SENSITIVITY

602a

603a

604a

600a

## FIG.8B

## FIG.9

## FIG.10A

FIG.10B

## FIG.10C

## FIG.11

CAPACITANCE CHANGE AMOUNT (ARBITRARY UNIT)
(RELATIVE VALUE WHEN VALUE OF CASE WHERE RECEPTION ELECTRODE HAS RECTANGULAR SHAPE IS SET TO ZERO)

DISTANCE (mm) BETWEEN SENSOR AND DETECTION OBJECT

## FIG.12

$\alpha = \infty$

$\alpha = 3$

$\alpha = 2$

$\alpha = 1.6$

$\alpha = 1$

## FIG.13

1300

1301

1304    1303

1302

## FIG.14

1400

1403

1402                                                                    1402

                                                                       1401

1404         1404                                                       1405

## FIG.15

**EUROPEAN SEARCH REPORT**

Application Number

EP 14 19 5759

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 380 040 A (POSSET ROBERT [BE]) 12 April 1983 (1983-04-12) | 1-15 | INV. G06F3/044 |
| Y | * column 1, line 6 - line 10 * * column 2, line 58 - column 3, line 33 * * column 6, line 38 - line 48 * * column 7, line 17 - line 23 * * Table in column 5, 6 * * figures 1, 4 * | 2 | |
| X | US 6 593 755 B1 (ROSENGREN BRIAN P [US]) 15 July 2003 (2003-07-15) * figure 2 * * column 3, line 21 - line 40 * | 1-15 | |
| X | US 2006/076985 A1 (MARTINEZ ROBERT E [US] ET AL) 13 April 2006 (2006-04-13) | 1,3-15 | |
| Y | * paragraph [0034] * * figure 2 * | 2 | |
| X | US 2002/190727 A1 (MORIMOTO HIDEO [JP]) 19 December 2002 (2002-12-19) * figure 3 * | 1-14 | TECHNICAL FIELDS SEARCHED (IPC) G06F |
| X | US 2003/222660 A1 (MORIMOTO HIDEO [JP]) 4 December 2003 (2003-12-04) * figure 3 * | 1-14 | |
| A | Anonymous: "Superellipse - Wikipedia, the free encyclopedia", , 1 October 2013 (2013-10-01), XP055174138, Retrieved from the Internet: URL:http://en.wikipedia.org/w/index.php?title=Superellipse&oldid=575351177 [retrieved on 2015-03-05] * page 1 * | 4-8, 10-14 | |

The present search report has been drawn up for all claims

| Place of search | Date of completion of the search | Examiner |
|---|---|---|
| Munich | 12 March 2015 | Seifert, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 19 5759

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2015

| Patent document cited in search report | | Publication date | Patent family member(s) | | Publication date |
|---|---|---|---|---|---|
| US 4380040 | A | 12-04-1983 | BE | 885095 A1 | 05-03-1981 |
| | | | CA | 1152603 A1 | 23-08-1983 |
| | | | CH | 640987 A5 | 31-01-1984 |
| | | | DE | 3036050 A1 | 16-04-1981 |
| | | | ES | 253278 U | 01-09-1981 |
| | | | FR | 2466908 A1 | 10-04-1981 |
| | | | IT | 1130506 B | 18-06-1986 |
| | | | JP | H0219570 B2 | 02-05-1990 |
| | | | JP | S5657227 A | 19-05-1981 |
| | | | NL | 8005282 A | 31-03-1981 |
| | | | SE | 450800 B | 27-07-1987 |
| | | | US | 4380040 A | 12-04-1983 |
| US 6593755 | B1 | 15-07-2003 | NONE | | |
| US 2006076985 | A1 | 13-04-2006 | NONE | | |
| US 2002190727 | A1 | 19-12-2002 | AT | 336744 T | 15-09-2006 |
| | | | CN | 1459021 A | 26-11-2003 |
| | | | DE | 60122386 T2 | 16-08-2007 |
| | | | EP | 1378737 A1 | 07-01-2004 |
| | | | US | 2002190727 A1 | 19-12-2002 |
| | | | WO | 02073148 A1 | 19-09-2002 |
| US 2003222660 | A1 | 04-12-2003 | CN | 1461943 A | 17-12-2003 |
| | | | HK | 1059468 A1 | 25-07-2008 |
| | | | JP | 4090939 B2 | 28-05-2008 |
| | | | JP | 2004191348 A | 08-07-2004 |
| | | | US | 2003222660 A1 | 04-12-2003 |
| | | | US | 2005057266 A1 | 17-03-2005 |

EPO FORM P0459

For more details about this annex : see Official Journal of the European Patent Office, No. 12/82

# EP 2 887 190 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012203901 A